# EUROPEAN PATENT APPLICATION

(11) **EP 1 937 044 A1**
(43) Date of publication of application: **25.06.2008**
(21) Application number: 06077306.6
(22) Date of filing: 22.12.2006
(51) Int. Cl.: H05K 3/10, H05K 3/00, B29C 45/17, B29C 45/00

(54) **Method for manufacturing a conductor**

(71) Applicant: Nederlandse Organisatie voor toegepast- natuurwetenschappelijk onderzoek TNO, 2628 VK The Hague (NL)
(72) Inventor: The designation of the inventor has not yet been filed
(74) Representative: van Loon, C.J.J.

(57) **Abstract**

Method for manufacturing a conductor (1) between at least one point A and at least one other point B, the conductor structure having a predefined geometrical shape, comprising steps of providing a mould (2) having an inner shape which is essentially similar to the predefined geometrical shape of the conductor to be manufactured, filling the mould with a viscous, hardenable synthetic material (3) and performing hardening the outside layer of the synthetic material in the mould. A pressure medium (4) is fed from A to B in order to drive out the still liquid or viscous part of the material and thus to form a conduit (5) throughout the hardened synthetic material and a conductive coating (6a, 6b) is applied inside the conduit throughout the hardened synthetic material.

## Description

### Field of the invention

The invention concerns a method for manufacturing a 2D or 3D conductor structure between at least one point A and at least one other point B, the conductor structure having a predefined geometrical shape.

### Background of the invention

Wiring structures in e.g. vehicles (cars, trucks, aeroplanes etc.) often include a carrier or support body, on which or in which a plurality of isolated copper wires are mounted. Where such a wiring structure is formed by one or more synthetic carriers comprising one or more metal conductors, the manufacturing of such structure is rather complex due to the fact that the metal conductor(s) have to be made in a separate process and inserted into a mould which, subsequently, is filled with a viscous, hardenable synthetic material, which encloses - entirely of partially - the metal conductor.

### Summary of the invention

One aim of the present invention is to provide an improved manufacture method for a wiring structure, having a shorter processing time and resulting in a precise and reliable product. Another aim of the invention is to provide an improved wiring structure.

The method for manufacturing a 2D or 3D conductor structure between at least one point A and at least one other point B, the conductor structure having a predefined geometrical shape, preferably comprises the steps of: provide a mould having an inner shape which is essentially similar to the predefined geometrical shape of the conductor to be manufactured and fill the mould with a viscous, hardenable synthetic material. Such a process is well known as e.g. injection moulding of thermoplastic of thermosetting synthetic resins. Next, perform hardening the outside layer of the synthetic material in the mould, e.g. by means of cooling (when using thermoplastic material) or heating (when using thermosetting material) the mould and in particular the wall of the cavity in which the synthetic material had been injected. Next a pressure medium is fed from A to B in order to drive out the still liquid or viscous part of the material and thus to form a conduit throughout the hardened synthetic material. After thus having made a hollow structure the outer shape is defined by the shape of the mould cavity, a conductive coating has to be applied inside the conduit throughout the hardened synthetic material. Well known in the art is a sequence of steps to be performed to make such a conductive coating, e.g. next sequence:
- etching the conduit's surface to get a roughened and hydrophilic surface for good bonding properties;
- surface sensitization, e.g. by adsorption of Sn ions to the surface;
- surface activation, e.g. by reduction of Pd ions to metallic Pd by means of the Sn ions, resulting in a metallizing base layer or seed layer that is catalytic to the subsequent chemical metallization process;
- metallizing and formation of a metal coating on the Pd seed layer by means of catalytic reduction of metal ions (e.g. Cu or Ni) from a solution that comprises both the relevant coating metal ions and a reduction chemical.

Instead of the mentioned catalysation steps a precatalysed synthetic material may be used to form a conduit from A to B.

All those steps can be performed by feeding the respective agents in liquid form through the conduit of synthetic material. The result of those steps is that the conduit has been provided of a (rather thin) metal coating inside the conduit. If it is desired to produce a wiring structure having a lower resistance, to be able to conduct relative large currents (e.g. of 100 Amps), the thin conductive metal layer inside the conduit can be thickened by means of electrolytic metallization.

Preferably, the conductive coating is applied to the inside surface of the conduit throughout the hardened synthetic material.

However, as an alternative or as an addition the conductive layer could be applied on the outer surface of an auxiliary conductor carrier. To that end, before filling the mould with a viscous, hardenable synthetic material, a carrier body is inserted in the mould having a shape which is essentially similar to the inner shape of the mould, however having a smaller diameter than it, and wherein, after hardening the outside layer of the synthetic material in the mould and feeding a pressure medium through it and driving out the liquid or viscous part of the material and forming a conduit throughout the hardened synthetic material, the conductive coating is applied to the outside surface of the carrier body.

Both options will be discussed below referencing to two exemplary embodiments.

### Exemplary Embodiments

Figure 1 shows schematically a wiring structure still within its injection mould;
Figure 2 shows schematically some stages in the manufacturing process of the first optional wiring structure;
Figure 3 shows schematically some stages in the manufacturing process of the second optional wiring structure.

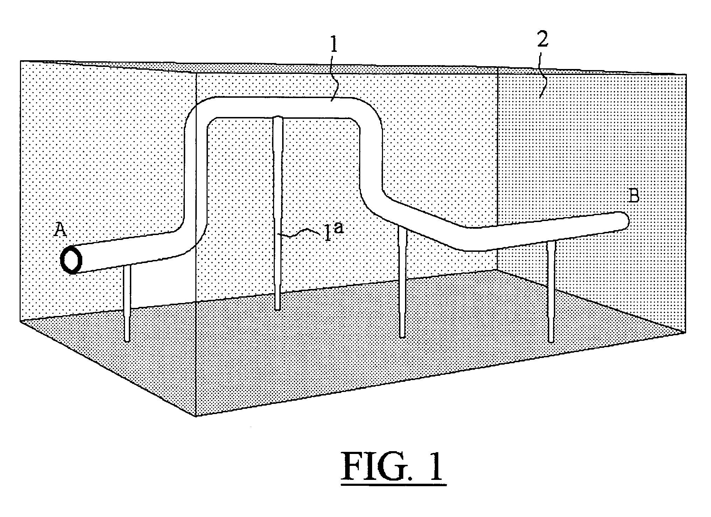

Figure 1 shows schematically an injection moulded part 1 between points A and B, which resides within an injection mould 2 by means of which it was made. Manufacturing such a moulded part 1 is generally known and understood by persons skilled in the art and does not need further explication. It is noted that the mould 2 may comprise two or more mould parts, may be including shift kernels, ejectors etc., which enable the part 1 to be released after the synthetic material has become solid. The mould 2 has an inner shape which is essentially similar to the predefined geometrical shape of the conductor to be manufactured. "Essentially", because it may be needed to provide part 1 with e.g. auxiliary parts 1a like (extra) sprues or supports members, ect., which may or may not be removed after the conductor has been completed.

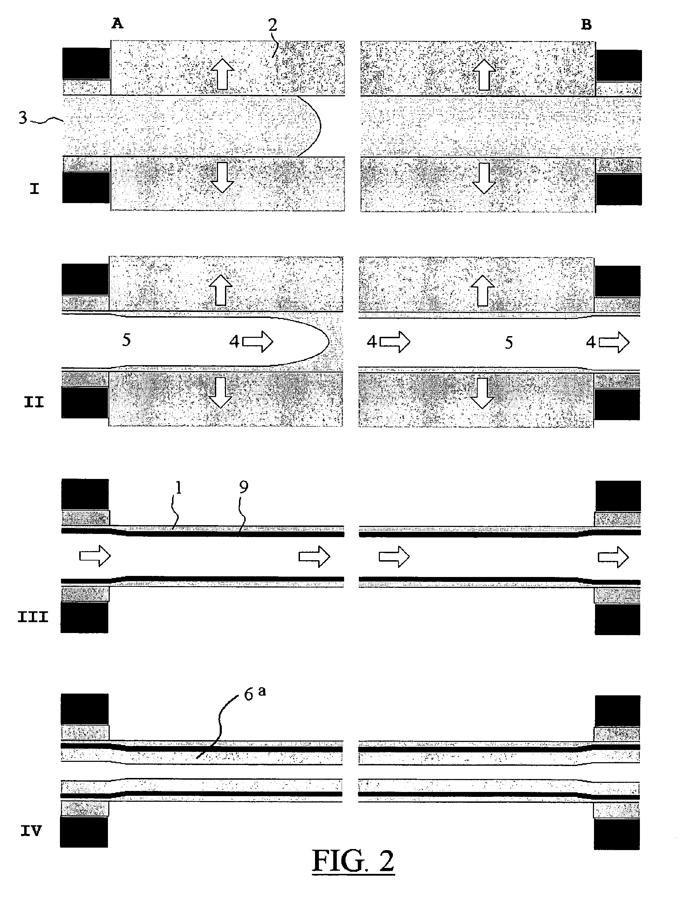

Figure 2 shows the subsequent process steps more in detail. The figure's left side corresponds with point A in figure 1 during the process steps; the right side with point B at the end of the process steps.

Step I includes to fill the mould 2 with a viscous, hardenable synthetic material 3. If material 3 is a thermoplastic material, it may be injected as a melt from the left side A. When the mould is cooled, the material 3 will solidify by extraction of heat, starting at the outside of the material 3. If material 3 is a thermosetting material, it may be injected at room temperature from the left side A. When the mould is heated, the material 3 will solidify by curing due the heat which is applied to the mould, starting at the outside of the material 3.

Step II illustrates hardening the outside layer of the synthetic material in the mould and feeding a pressure medium 4, e.g. air or water, from A to B in order to drive out the still liquid or viscous part of the material 3 and thus to form a conduit 5 throughout the hardened synthetic material.

After this step the mould 2 could mainly be removed: see up/down arrows at steps I and II, indicating the mould's suggested release direction.

Steps III and IV illustrate applying a conductive coating (6a, 6b) inside the conduit throughout the hardened synthetic material. In step III the result is shown of a number sub-steps, like:
- etching the conduit's surface to get a roughened and hydrophilic surface for good bonding properties;
- surface sensitization, e.g. by adsorption of Sn ions to the surface;
- surface activation, e.g. by reduction of Pd ions to metallic Pd by means of the Sn ions, resulting in a metallizing base layer or seed layer that is catalytic to the subsequent chemical metallization process (It is noted that instead of the catalysation steps a precatalysed synthetic material could be used to form part 1);
- metallizing and formation of a metal coating on the Pd seed layer by means of catalytic reduction of metal ions (e.g. Cu or Ni) from a solution that comprises both the relevant coating metal ions and a reduction chemical. All those steps can be performed by feeding the respective agents in liquid form through the conduit 5. The result of those sub-steps is that the conduit has been provided of a metal coating 9 inside the conduit. As can be seen, in figure 2 the conductive coating 9 is applied to the inside surface of the conduit throughout the hardened synthetic material.

In step IV the conductive coating 9 is thickened by means of electrolytic metallization - using conductive coating 9 as receiving electrode - resulting in a substantial metal conductor 6a inside the inside conduit 5.

In this way various wiring structures may be manufactured, consisting of a metal conductor 6a, covered by a synthetic insulation layer 3.

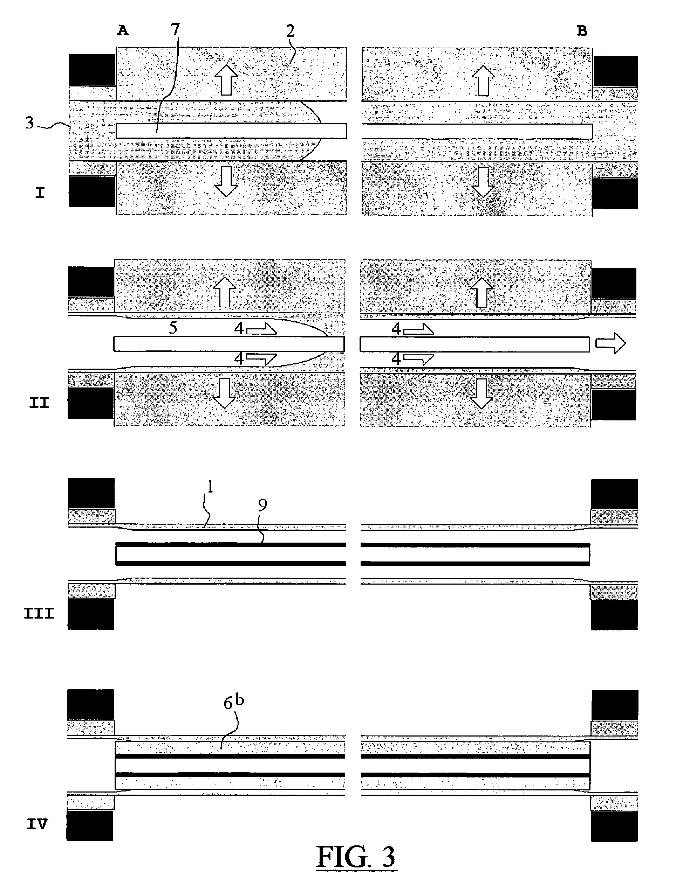

Figure 3 represents an alternative for the previous. Only the differences will be discussed. Before filling the mould 2 with a viscous, hardenable synthetic material, a carrier body 7 is inserted in the mould having a shape which is essentially similar to the inner shape of the mould, however having a smaller diameter than it. The carrier body 7 may comprise e.g. support extensions (not shown) to centre the carrier body 7 in the inner shape of the mould. Preferably the carrier body 7 has been made in a preceding step (not illustrated), within the same mould 2, by means of additional mould parts, which e.g. may have a release direction perpendicular to the release direction indicated by the arrows in figures 2 and 3.

Also in this alternative embodiment, after hardening the outside layer of the synthetic material in the mould (step I) and feeding a pressure medium through it and driving out the liquid or viscous part of the material and thus forming a conduit throughout the hardened synthetic material (step II), the conductive coating 6b is applied to the outside surface of the carrier body 7, using the same sub-steps as discussed with figure 2.

Figure 3 shows that the conductive layer 6b is only applied on the surface of member 7. This may be performed by using for the conduit 3 a synthetic material which - different from the situation in figure 2 - is not suited for the application of the sub-steps of surface sensitization, surface activation, forming a metallizing base layer or seed layer and metallizing and formation of a metal coating, and thus not for the final electrolytic metallization process, as for member 7 a synthetic material is chosen which is suited for successful application of those sub-steps and final electrolytic metallization step.

However, when for both, (hollow) part 1 and the inside auxiliary member 7, materials are chosen which are suited for successful application of those sub-steps and final electrolytic metallization step, the metallization process may be performed on both, the inside surface of hollow part 1 and the outside surface of part 7, resulting in a electrolytically metallized inside surface of hollow part 1 and a electrolytically metallized outside surface of part 7.

## Claims

1. Method for manufacturing a conductor (1) between at least one point A and at least one other point B, the conductor structure having a predefined geometrical shape, comprising next steps:
- provide a mould (2) having an inner shape which is essentially similar to the predefined geometrical shape of the conductor to be manufactured;
- fill the mould with a viscous, hardenable synthetic material (3);
- perform hardening the outside layer of the synthetic material in the mould;
- feed a pressure medium (4) from A to B in order to drive out the still liquid or viscous part of the material and thus to form a conduit (5) throughout the hardened synthetic material;
- apply a conductive coating (6a, 6b) inside the conduit throughout the hardened synthetic material.

2. Method according to claim 1, wherein the conductive coating is applied to the inside surface of the conduit throughout the hardened synthetic material.

3. Method according to claim 1, wherein, before filling the mould with a viscous, hardenable synthetic material, a carrier body (7) is inserted in the mould having a shape which is essentially similar to the inner shape of the mould, however having a smaller diameter than it, and wherein, after hardening the outside layer of the synthetic material in the mould and feeding a pressure medium through it and driving out the liquid or viscous part of the material and forming a conduit throughout the hardened synthetic material, the conductive coating is applied to the outside surface of the carrier body.

4. Wiring structure manufactured by the method according to any preceding claims.
